# EUROPÄISCHE PATENTANMELDUNG

(11) **EP 0 823 736 A2**
(43) Veröffentlichungstag der Anmeldung: **11.02.1998**
(21) Anmeldenummer: 97250228.0
(22) Anmeldetag: 05.08.1997
(51) Int. Cl.: H01L 29/732, H01L 21/331

(54) **Vertikaler Bipolartransistor und Verfahren zu seiner Herstellung**

(30) Priorität: 05.08.1996 DE 19632412
(71) Anmelder: Hu, Sifu, 13629 Berlin (DE)
(72) Erfinder: Hu, Sifu, 13629 Berlin (DE)
(74) Vertreter: Pfenning, Meinig & Partner

(57) **Zusammenfassung**

Es wird ein vertikaler Bipolartransistor für den Hochleistungsbereich vorgeschlagen, der aus einer Poly-Si/TiSi₂-Emitterschicht, einer Basisschicht und einer kammartigen Kollektorschicht besteht, wobei ein kammartiger Isolationsgraben (5) mit der kammartigen Kollektorschicht verzahnt ist. Weiterhin wird ein mehrschichtiges metallisiertes Elektrodensystem mit hoher Zuverlässigkeit verwendet. Der Isolationsgraben erstreckt sich bis tief in das Substrat und die Bodenfläche des kammartigen Isolationsgrabens ist größer als die Fläche des Kollektorübergangs.

## Beschreibung

Die Erfindung bezieht sich auf einen vertikalen Bipolartransistor nach dem Oberbegriff des Hauptanspruchs sowie auf ein Verfahren zur seiner Herstellung.

Herkömmliche vertikale Bipolartransistoren für den Hochfrequenz- und Hochleistungsbereich, beispielsweise für leistungselektronische Schaltungen, weisen als Schaltelemente eine in die Tiefe eines Substrats sich erstreckende Schichtenfolge beispielsweise als npn- bzw. pnp-Transistor auf. Im Betrieb wird der am tiefsten in das Substrat eingebettete Kollektor gewöhnlich unter eine Gegenvorspannung betrieben, so daß sich an dem zugehörigen Basis-Kollektor-Halbleiterübergang eine Raumladungszone ausbildet, die sich weit in das Kollektorgebiet in die Tiefe des Substrates erstreckt. Dabei verlaufen die Feldlinien des durch die Gegenspannung aufgebauten elektrischen Feldes lediglich in zentralen Bereichen des Kollektors einigermaßen parallel und homogen. In den seitlichen Randbereichen des Kollektors treten jedoch sehr hohe Feldstärken auf, da dort das Raumladungsgebiet sich stark in Richtung der Oberfläche des Transistors erstreckt und die Feldlinien sich ebenfalls in Richtung der Substratoberfläche krümmen. Dadurch ergibt sich insbesondere eine geringe Durchbruchspannung des vertikalen Bipolartransistors.

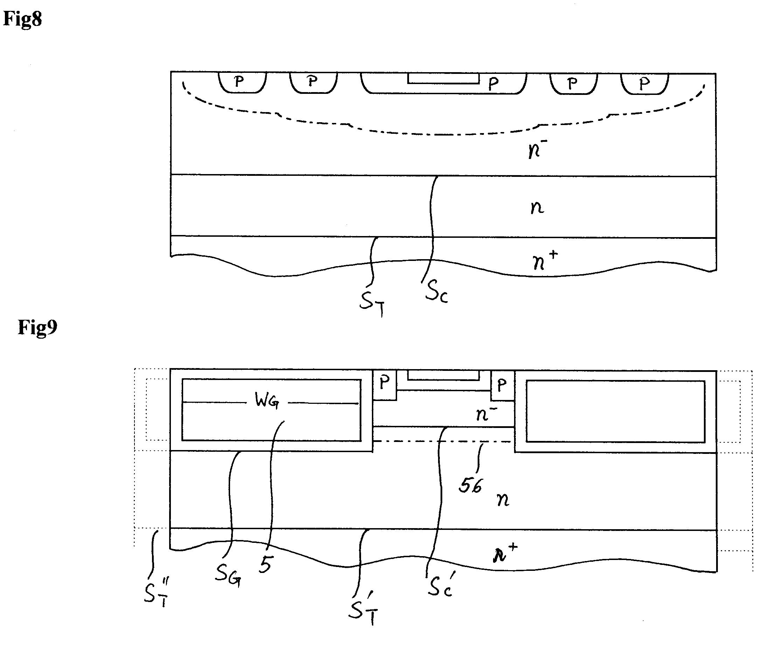

Zur Überwindung dieser Krümmung des Raumladungsgebietes und damit zur Erhöhung der Durchbruchfestigkeit des Transistors werden nach dem Stand der Technik die Transistoren mit dotierten Schutzringen umgeben, die das Raumladungsgebiet in seitlicher Richtung ausdehnen und hierdurch die starke Krümmung der Feldlinien in Richtung der Oberfläche verringern. Ein solcher Transistor ist in Fig. 8 dargestellt. Durch eine Vielzahl von Schutzringen läßt sich folglich die Durchbruchspannung der Transistsoren erhöhen. Nachteilig an dieser herkömmlichen Technik ist, daß die Schutzringe einen sehr hohen Platzbedarf haben und dadurch die Packungsdichte der Transistoren gering ist. Weiterhin ergibt sich durch die Schutzringe ein komplizierter Aufbau der vertikalen Bipolartransistoren. Dennoch werden heutzutage bis zu zwanzig Schutzringe um Hochleistungstransistoren angeordnet, um das Problem der geringen Durchbruchfestigkeit in den Griff zu bekommen.

Andererseits ist es bekannt, einzelne Transistoren von anderen Transistoren durch isolierende Gräben zu trennen. Dabei werden zwischen den einzelnen Transistoren eines Schaltkreises mit Abstand zu diesen jeweiligen Transistoren Gräben geätzt, die anschließend mit isolierendem Material aufgefüllt werden. Der Anwendungsbereich dieser vertikalen bipolaren Transistoren betrifft Halbleiterbauelemente von hohen Geschwindigkeiten und sehr kleinem Leistungsverbrauch.

Der Erfindung liegt die Aufgabe zugrunde, einen vertikalen Bipolartransistor für den Hochfrequenz- und Hochleistungsbereich zu schaffen, dessen Eigenschaften wie beispielsweise Spannungsfestigkeit oder Frequenzverhalten gegenüber dem Stand der Technik verbessert sind und der eine große Packungsdichte aufweist. Weiterhin soll ein Verfahren zu seiner Herstellung zur Verfügung gestellt werden.

Diese Aufgabe wird erfindungsgemäß durch die kennzeichnenden Merkmale des Hauptanspruchs in Verbindung mit den Merkmalen des Oberbegriffs und durch die Merkmale der nebengeordneten Ansprüche gelöst.

Erfindungsgemäß ist ein kammartiger Isolationsgraben und eine kammartige Kollektorschicht vorgesehen, wobei die "Zinken" der kammartigen Ausbildung der Kollektorschicht und des Isolationsgrabens ineinandergreifen. Auf diese Weise kann eine große Packungsdichte erzielt werden. Durch die Ausbildung des Isolationsgrabens ist dieser der Transistormitte sehr nahe und hat ein ausgezeichnetes Temperaturleitvermögen, wodurch die Wärme aus der Transistormitte leicht abgeführt werden kann. Es gibt daher eine gleichmäßige Temperaturverteilung und der Kollektorübergang weist eine relativ geringe Temperatur auf. Durch die zum Stand der Technik vergrößerte Umfangslänge zu den Flächen des Kollektors kann der Innenwiderstand des Transistors gesenkt werden und es wird die warme Stabilität des Transistors bei Erhöhung der Ausgangsleitung verbessert.

Durch den erfindungsgemäßen Isolationsgraben wird die Raumladungszone des Kollektors vollständig in einem Tieffang eingeschlossen, d.h. der Isolationsgraben erstreckt sich soweit in das Substrat, daß bei jeder beliebigen Gegenvorspannung bis zur Durchbruchspannung hin, der vor dieser Gegenvorspannung erzeugte Raumladungsbereich in dem Tieffang eingeschlossen ist. Sie kann daher nicht mehr seitlich die Oberfläche erreichen, wodurch Oberflächeneffekte durch die Raumladungszonen des Kollektors vermieden werden. Insbesondere verbessern sich hierdurch die parasitären Parameter des erfindungsgemäßen Bipolartransistors. Durch Einschluß der Raumladungszone in den genannten Tieffang wird in der Kollektorschicht des Transistors ein homogenes elektrisches Feld erzeugt, das sich nicht mehr seitlich des Transistors zur Oberfläche des Substrates krümmt. Dadurch treten keine Feldstärkespitzen mehr auf und es ergibt sich eine höhere Spannungsfestigkeit des erfindungsgemäßen Transistors.

Der Isolationsgraben befindet sich direkt angrenzend an den Kollektor und auch an die Basis, wodurch die seitlichen gekrümmten Übergangsbereiche zwischen Basis und Kollektor beseitigt werden, wodurch die Durchschlagspannung an dem Kollektorübergang erheblich erhöht werden kann. Es ergibt sich ein besseres Verhältnis zwischen der Fläche des Emitter-Basiskontaktes und der Fläche des Basis-Kollektorkontaktes. Auch dies führt dazu, daß der erfindungsgemäße Transistor einen größeren Strom und eine größere Leistung liefern kann.

Weiterhin ist durch die erfindungsgemäße Anordnung eine höhere Dotierung der Transistorschichten und folglich auch eine höhere Stromdichte bei gegebener Spannungsfestigkeit möglich.

Die höhere Dotierung erlaubt eine höhere Grenzfrequenz, bei der der Transistor noch zuverlässig betrieben werden kann, da die Raumladungszone bei höherer Dotierung verglichen mit dem Stand der Technik weniger ausgedehnt ist.

Insgesamt ist zu sagen, daß der erfindungsmäße Bipolartransistor sich besonders als Hochleistungsbauelement und als Hochfrequenzbauelement für sämtliche denkbaren Anwendung eignet.

Weiterhin ist vorteilhaft, daß der erfindungsgemäße Bipolartransistor keine Schutzringe und daher einen verglichen mit dem Stand der Technik erheblich geringeren Flächenbedarf aufweist. Bei der vorliegenden Erfindung ersetzt der Isolationsgraben 5 die bisher bekannte Ringschutztechnik (siehe Fig. 8), durch die hohe Spannungsbelastbarkeit erzielt werden soll. Fig. 9, die einen Schnitt durch einen Teil des erfindungsgemäßen Bipolartransistors darstellt, zeigt, daß der Einsatz des Isolationsgrabens die funktionelle Fläche SC' der Kollektorübergangszone des Transistors verkleinert (S_{C'}<S_{C}). Dadurch wird die Grenzfrequenz des Transistors höher. Weiterhin ist aus Fig. 9 zu erkennen, daß mit der Vergrößerung der Breite W_{G} des Grabens sich die Bodenfläche S_{G} des Grabens vergrößert. Die funktionelle Fläche S_{C'} wird aber dabei nicht geändert. Wenn die Bodenfläche S_{T'} des Transistors sich zu S_{T''} vergrößert, vergrößert sich auch die Wärmeleitfläche des Transistors, wodurch der Wärmewiderstand gesenkt wird. Auf diese Weise kann eine höhere Ausgangsleistung durch die Vergrößerung des Grabens gewonnen und die hohe Arbeitsfrequenz kann gleichzeitig erhalten bleiben. Durch die in den Unteransprüchen angegebenen Maßnahmen sind vorteilhafte Weiterbildungen und Verbesserungen möglich.

Dadurch, daß die Emitter- und Basiselektroden des Transistors mehrschichtige metallisierte Elektroden sind, kann die Zuverlässigkeit über eine lange Lebensdauer gewährleistet werden, selbst wenn mit hohem Strom und hoher Leistung gearbeitet wird.

Das erfindungsgemäße Verfahren läßt sich insbesondere sehr gut mit einem selbstjustierenden Verfahren verbinden, wodurch besonders planparallele Emitter-Basis- bzw. Basis-Kollektor-Kontaktflächen hergestellt werden.

Werden die dem Transistor zugewandten seitlichen Flächen des Isolationsgrabens in die Tiefe des Substrats aufeinanderlaufend unter einem vorgegebenen Winkel geneigt, so verengt sich der Querschnitt des Kollektors mit der Tiefe des Substrates. Bei einer derartigen Neigung ergibt sich ein weiter verbeserter Einschluß des Raumladungsgebietes des Kollektors und damit eine noch bessere Spannungsfestigkeit des erfindungsgemäßen Transistors.

Werden dagegen die seitlichen Flächen des Isolationsgrabens in die Tiefe des Substrats auseinanderlaufend geneigt, so erweitert sich die Fläche des Kollektors in die Tiefe des Substrates. Bei einem derartig ausgebildeten Bipolartransistor kann die Stromstärke weiter erhöht werden und die Wärmeableitung aus dem Transistor ist durch den sich erweiternden Querschnitt in Richtung der Tiefe des Substrats verbessert. Weiterhin zeigen derartige vertikale Bipolartransistoren ein verbessertes lineares Frequenzverhalten und es ist möglich, einen Transistor mit noch höherer Grenzfrequenz zu erhalten.

Ausführungsbeispiele der Erfindung sind in der Zeichnung dargestellt und werden in der nachfolgenden Beschreibung näher erläutert. Es zeigen:
- Fig. 1A: einen Grundriß der Grundeinheitsstruktur des vertikalen Bipolartransistors mit kammartigem Kollektor und kammartigem Isolationsgraben,
- Fig. 1B: einen Querschnitt der Grundeinheitsstruktur entsprechend der Schnittlinie 1B-1B der Fig. 1A,
- Fig. 1C: einen Querschnitt der Grundeinheitsstruktur entsprechend der Schnittlinie 1C-1C nach Fig. 1A,
- Fig. 2: einen Schnitt durch einen vertikalen Bipolartransistor mit kammartigem, sich nach innen neigendem Isolationsgraben,
- Fig. 3: einen Schnitt durch einen vertikalen Bipolartransistor mit kammartigem, sich nach außen neigendem Isolationsgraben,
- Fig. 4A: einen Grundriß des vertikalen Bipolartransistors in einem Zwischenschritt des Herstellungsverfahrens,
- Fig. 4B: einen Schnitt entsprechend der Schnittlinie 4B-4B in Fig. 4A,
- Fig. 4C bis 4G: Schnittbilder des vertikalen Transistors während seiner Herstellung,
- Fig. 5A bis 5C: Schnittbilder des vertikalen Bipolartransistors mit geneigten Isolationswänden während seiner Herstellung,
- Fig. 6A bis 6C: Schnittbilder des vertikalen Bipolartransistors mit geneigtem Isolationsgraben während seiner Herstellung nach einem anderen Ausführungsbeispiel,
- Fig. 7A: einen Grundriß des Emitters und der mehrschichtigen metallisierten Elektroden,
- Fig. 7B bis 7C: Schnittbilder des Bipolartransistors während der Herstellung entsprechend der Schnittlinie 7B-7B nach Fig. 7A,
- Fig. 8: einen Schnitt durch einen Bipolartransistor nach dem Stand der Technik, und
- Fig. 9: eine schematische Darstellung des erfindungsgemäßen Bipolartransistors zur Erläuterung der Flächenabmessung.

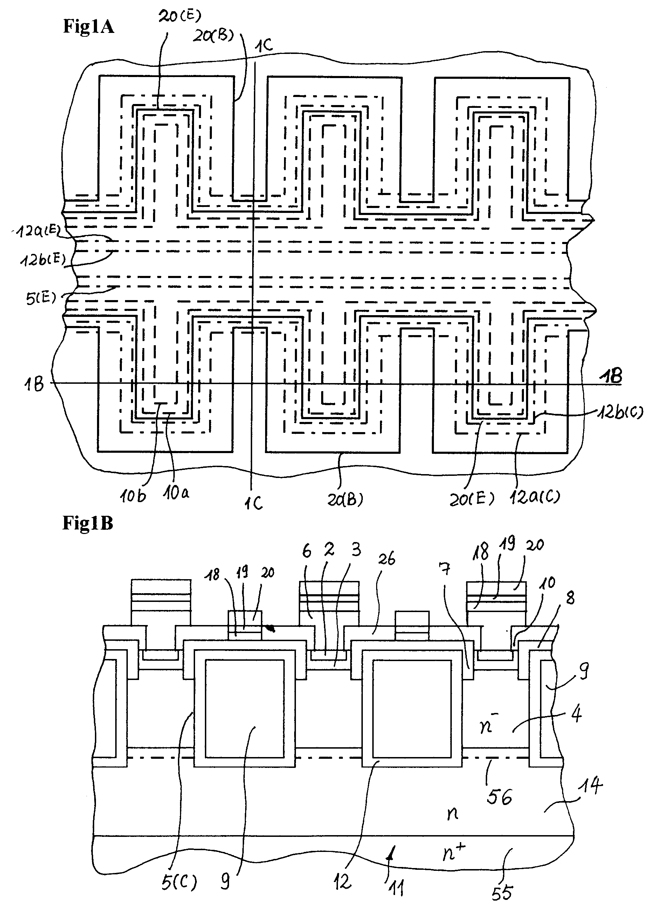

In Fign. 1A bis 1C ist ein vertikaler Bipolartransistor für den Hochleistungs- und Hochfrequenzbereich dargestellt, der in vertikaler Schichtenfolge und in ein Substrat 11 eingearbeitet eine n-dotierte Emitterschicht 2, eine p-dotierte Basisschicht 3 sowie eine n-dotierte Kollektorschicht 4 aufweist. Der Emitter 2 ist über eine leitende Schicht 6 an der Oberfläche des Substrats 11 kontaktiert und die Basis 3 besitzt eine Kontaktierung 8 über einen p⁺-dotierten Bereich 7. Die die Kontaktierung darstellende leitende Schicht 6 und die Kontaktierung 8 sind über eine isolierende Schicht 10 voneinander getrennt.

Der vertikale Bipolartransistor ist durch einen vertikalen Isolationsgraben 5 seitlich begrenzt, der sich von der Oberfläche des Substrats in dessen Tiefe erstreckt. Die Wände des Isolationsgrabens 5 werden von einer isolierenden SiO₂-Schicht gebildet und der Innenraum zwischen den Grabenwänden 12 ist mit Polysilizium als Füllmaterial 9 gefüllt.

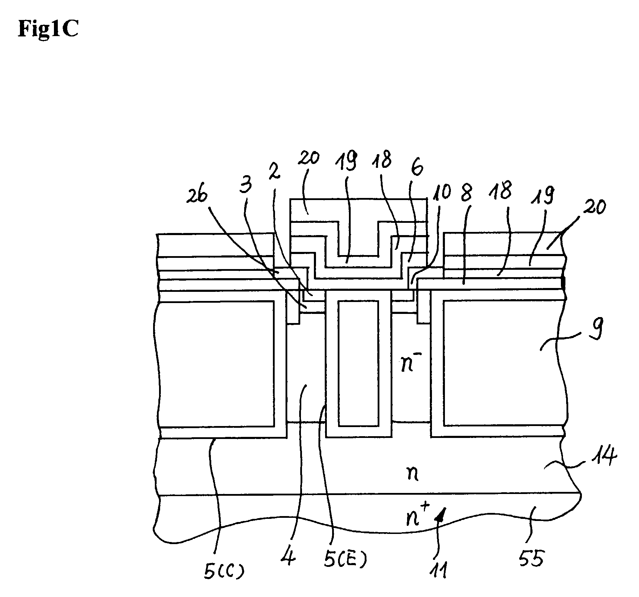

Wie aus Fig. 1A in Verbindung mit Fig. 1B und Fig. 1C zu erkennen ist, hat der Bipolartransistor eine kammartige oder fingerartige Struktur, wobei die verschiedenen Schichten in Fig. 1A gestrichelt gezeichnet sind. Der Bipolartransistor weist einen weiteren mittleren Isolationsgraben 5 auf, der in Fig. 1C zu erkennen ist. Die Innenseite und Außenseite der Wände 12 des mittleren Isolationsgrabens 5(E), der dem Emitter 3 zugewandt ist, sind mit 12a(E) und 12b(E) bezeichnet. Die Innen- und Außenseiten der Wände des kammartigen Isolationsgrabens 5(C) sind mit 12a(C) und 12b(C) bezeichnet. Die Bezugszeichen 20(B und 20(E) stellen die Elektroden auf der Basis und auf dem Emitter dar, die in diesem Fall aus Aluminium bestehen. Sämtliche Elektroden bilden ein mehrschichtiges Elektrodensystem 18, 19, 20, die weiter unten genauer beschrieben werden. Das Bezugszeichen 26 stellt ein Kontaktbondfenster der Basis dar.

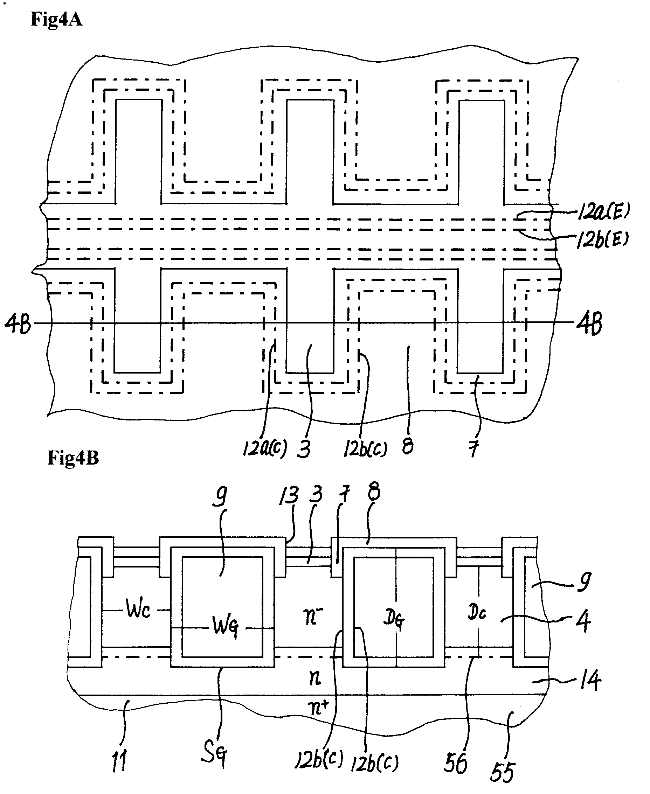

Aus den Figuren ist zu erkennen, daß der Kollektor 4 und der Isolationsgraben 5, die beide kammartig ausgebildet sind, ineinandergreifen, wobei dieser kammartige Kollektor und der kammartige Isolationsgraben eine Besonderheit dieser Erfindung sind. In Fign. 4A bis 4G ist die Herstellung des Transistors etwas näher erläutert. Die obere Fläche des Isolationsgrabens 5 ist mit p⁺-dotiertem Polysilizium als Kontaktierung 8 abgedeckt. Dabei ist entsprechend Fig. 4B zu erkennen, daß der kammartige Isolationsgraben 5 durch das p⁺-dotierte Polysilizium 8 mit dem kammartigen Kollektor 4 selbstjustiert ist. Der Isolationsgraben 5 ist direkt mit dem kammartigen Kollektor 4 verbunden, wobei weiterhin für die Erfindung wesentlich ist, daß die Breite des Armes bzw. "Zinkens" des kammartigen Isolationsgrabens 5 W_{G} breiter als der entsprechende Teil des kammartigen Kollektors W_{C} ist. Die Tiefe des kammartigen Isolationsgrabens 5 D_{G} soll mindestens um 2 µm größer sein als die Tiefe der Raumladungszone, deren Grenze durch das Bezugszeichen 56 angegeben ist, wobei diese Grenze bei einer Spannung gilt, die knapp unter der Durchschlagspannung liegt. Insgesamt ist die Tiefe des kammartigen Isolationsgrabens vorzugsweise 5 < D_{G} < 17 µm. Je tiefer der Isolationsgraben ist, desto mehr kann der Parasitwiderstand des Isolationsgrabens vermindert werden. Ein zu große Tiefe ist aber nicht günstig für die Wärmeabführung des Kollektors 4. Der Unterschied von 2 µm ist ein optimaler Wert.

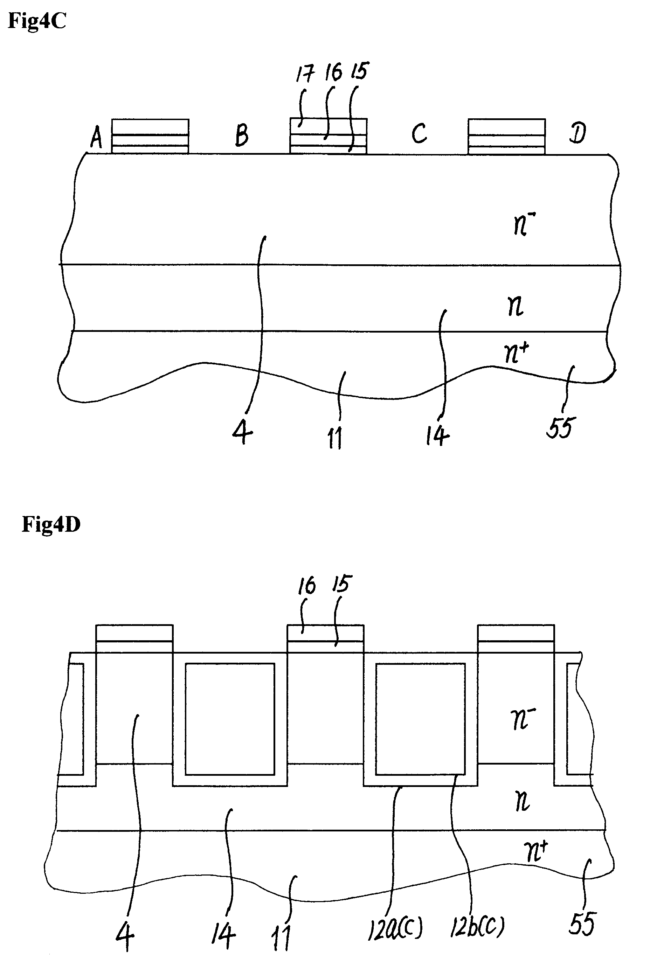

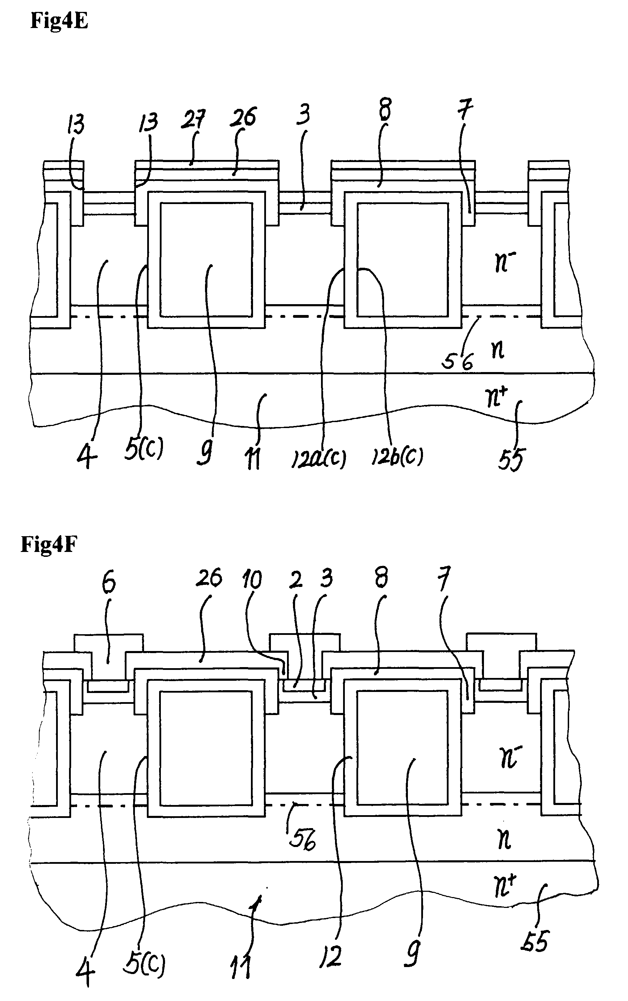

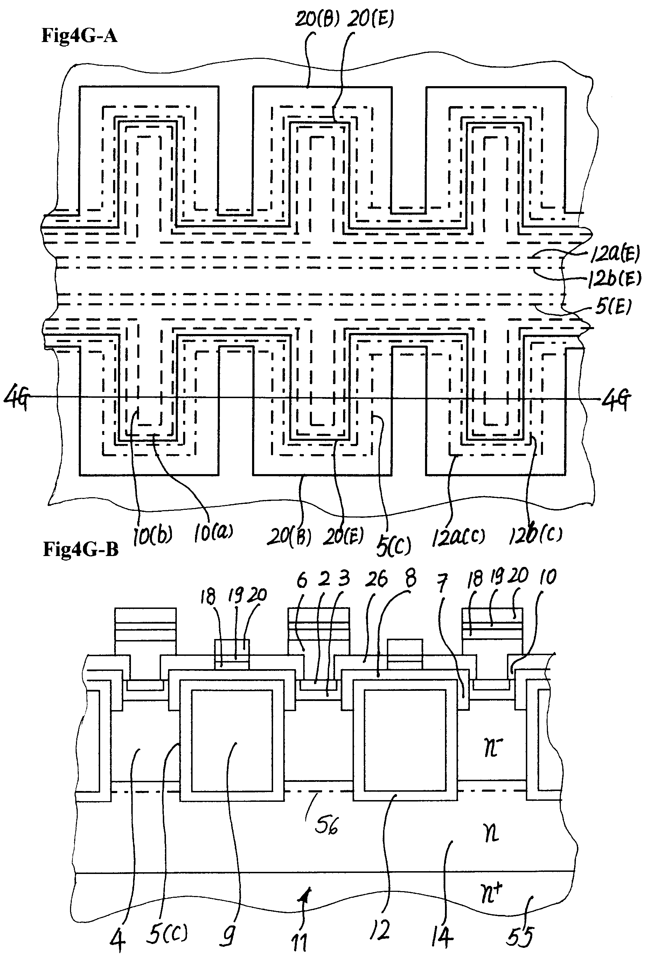

Sowohl aus der Fign. 4 als auch aus der Fign. 1 ist zu erkennen, daß das Substrat 11 aus mehreren Schichten gebildet wird. Zunächst wird ein einkristallines n⁺-Halbleitersubstrat 55 bereitgestellt, das mit As oder Sb dotiert ist. Auf diesem n⁺-Si-Substrat 55 bildet sich eine mit As dotierte n-Epitaxieschicht 14 aus, auf der sich eine weitere mit As dotierte n⁻-Epitaxieschicht 4 ausbildet. Diese drei Schichten bilden ein Halbleitersubstrat 11 (siehe Fig. 4C). Auf diesem Halbleitersubstrat werden nacheinander drei Isolationsschichten 15, 16, 17 hergestellt, eine dünne SiO₂-Schicht 15, eine SiN-Schicht 16 und eine dicke SiO₂-Schicht 17. Mit Hilfe von Fotolackverfahren und RIE-Ätzverfahren werden kammartige Isolationsfenster A, B, C, D gebildet, die die n⁻-Epitaxieschicht 4 enthüllen.

Entsprechend Fig. 4D wird mit Hilfe des RIE-Ätzverfahrens die n⁻-Epitaxieschicht 4 bis zur Oberfläche der n-Epitaxieschicht 14 durchgeätzt, wodurch der Isolationsgraben 5 entsteht. Mit Hilfe der SiN-Schicht 16 als Abdeckung bildet sich unter Anwendung der LOCOS-Oxidierung eine SiO₂-Isolationsfolie auf der Innenwand 12b(C) des kammartigen Isolationsgrabens 5. Unter Anwendung des CVD und Epitaxieverfahrens lagert sich Polysilizium im Graben ab und füllt diesen aus, wodurch der kammartige Isolationsgraben 5 entsteht. Die Reste der Si-Schicht werden mit dem CMP-Verfahren weggebracht und die SiN-Schicht 16 wird als Abdeckung genutzt, um das im Isolationsgraben sich befindende Polysilizium um 300 nm wegzuätzen. Mittels LOCOS-Oxidierung wird eine SiO₂-Isolationsschicht auf der oberen Fläche des kammartigen Isolationsgrabens 5 gebildet, so daß sich ein rundum durch die Wände 12 begrenzter Graben bildet. Anschließend werden die drei Isolationsschichten (Fig. 4C) 15, 16, 17 naß weggeätzt und entsprechend Fig. 4E wird auf dem gesamten Halbleitersubstrat eine p⁺-Polysiliziumschicht 8, eine SiO₂-Schicht 26 und eine SiN-Schicht 27 abgelagert. Mit Hilfe des Fotolackverfahrens und des RIE-Verfahrens wird eine Struktur aus p⁺-Polysilizium 8/SiO₂ 26/SiN gebildet, die mit dem Fingerbild des kammartigen Isolationsgrabens 5 übereinstimmt. Zugleich besteht ein Basiselektrodenfenster. Durch die Ausdiffusion von im p⁺-Polysilizium enthaltenen Bor-Atomen in die n⁻-Epitaxieschicht 4 und durch die Bor-Ionenimplantation wird selbstjustiert der kammartige Kollektorübergang gebildet, wobei die Übergangsfläche des kammartigen Kollektors rechtwinklig gegen die Seitenwände 12 des kammartigen Grabens 5 anstoßen. Durch Ausdiffusion der Bor-Atome im p⁺-Polysilizium bildet sich außerdem die Außenbasiselektrodenzone 7.

Entsprechend Fig. 4F wird zunächst eine SiO₂-Folie, die B enthält abgelagert. Dann bildet sich mit Hilfe des RIE-Verfahrens und Selbstjustieren die Seitenwand des Emitters 2. Anschließend wird die SiN-Folie mittels H₃PO₄ weggebracht. Es wird eine mit As dotierte Polysiliziumschicht abgelagert, mit Hilfe von Masken und dem RIE-Verfahren entsteht der mit As dotierte Polysiliziumemitter, der gleichfalls eine kammförmige Struktur aufweist. Anschließend wird die p⁺-Polysiliziumschicht geätzt und ein Anschlußfenster wird entsprechend Fig. 4G-B gebildet. Es wird eine 100 nm dicke Ti-Schicht abgelagert und durch einen anschließenden RTA-Prozeß wird auf der p⁺-Polysiliziumschicht in der Basisanschlußöffnung und auf der mit As dotierten Polysiliziumschicht des Emitters selbstjustiert eine TiSi₂-Schicht erzeugt, wodurch der Polysilizium/TiSi₂-Emitter gebildet wird. Im Kontaktfenster der Basiselektrode und auf dem mit As dotierten Polysiliziumemitter bildet sich eine TiSi₂ unter Selbstjustierung.

Mit Lösungsmittel von NH₄OH/H₂O₂/H₂O wird das unreagierende Ti weggebracht und unter Abscheidung einer TiN-Schicht und einer AlSiCu-Schicht oer Goldschicht ein mehrschichtig metallisiertes Eletrodensystem aus dotiertem Polysilizium-TiSi₂/TiN/AlSiCu gebildet. Auf diese Weise entsteht der vertikale Bipolartransistor mit kammartigem Kollektor, wobei der Emitter eine Breite von 72 µm aufweist.

Der in den Fign. 1 und 4 gezeigte vertikale Bipolartransistor wird mit einem selbstjustierenden Verfahren hergestellt. Dadurch können planparallele Übergänge zwischen Emitter 2 und Basis 3 sowie zwischen Basis 3 und Kollektor 4 erzeugt werden. Die Planparallelität dieser Grenzflächen zwischen unterschiedlich dotierten Schichten ermöglicht ein besonders homogenes elektrisches Feld über den Transistor.

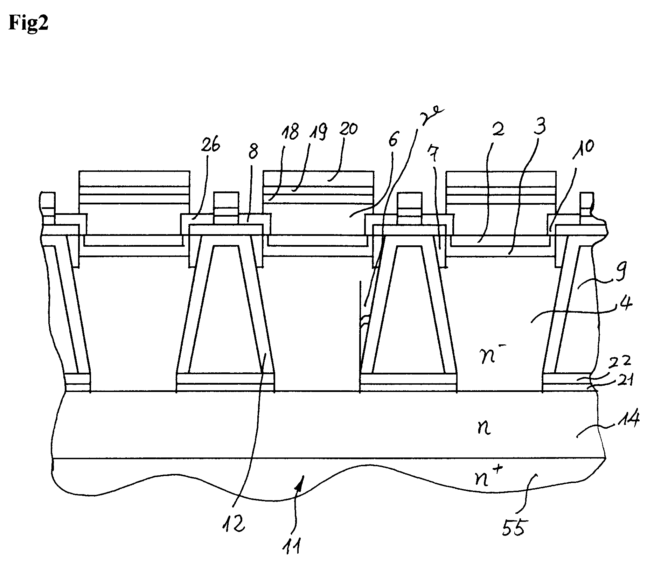

Fig. 2 zeigt ein weiteres Ausführungsbeispiel des vertikalen Bipolartransistors. Dabei bezeichnen gleiche Bezugszeichen wie in Fig. 1 die gleichen Elemente.

Der in Fig. 2 gezeigte Transistor besitzt gleichfalls einen kammartigen Isolationsgraben 5, dessen zur Basisschicht 3 und Kollektorschicht 4 orientierten Seitenwände 12 in Richtung der Tiefe des Substrats 11 aufeinanderzulaufen und unter einem bestimmten Winkel δ gegen die Vertikale geneigt sind. Dadurch verengt sich der Querschnitt des Kollektors 4 in der Tiefe des Substrats 11 zunehmend, wodurch der Einschluß der Raumladungsgebiets des Kollektors weiter verbessert wird.

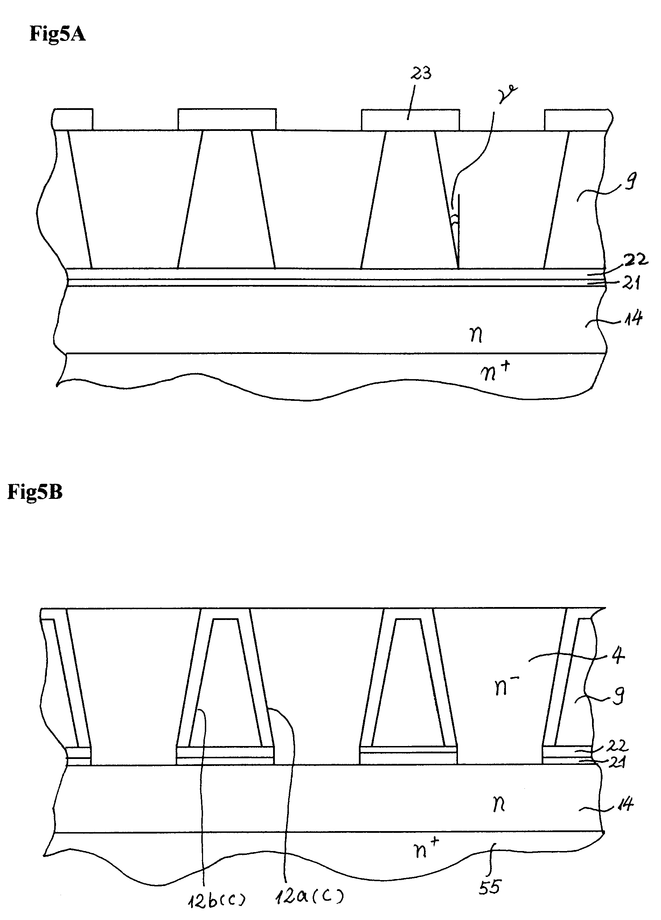

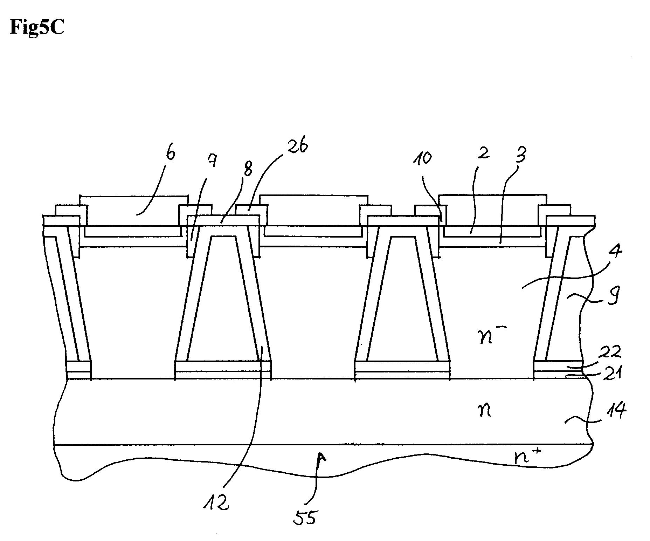

Die Fign. 5A bis 5C zeigen die Verfahrensschritte der Herstellung des Ausführungsform nach Fig. 2. Auch hier weisen gleiche Bezugszeichen gleiche Bauelemente auf. In Fig. 5A ist dargestellt, daß sich auf n-Epitaxieschicht 14 eine dünne SiO₂-Schicht 21 bildet. Mit Hilfe des CVD-Verfahrens wird eine Si₃N₄-Schicht 22 abgeschieden, so daß sich eine zweischichtige dünne Struktur bildet. Auf dieser Struktur wird epitaxisches Polysilizium als Füllungsmaterial 9 aufgewachsen, dessen Dicke zwischen 5 bis 17 µm liegt. Auf diese Polysiliziumschicht 9 wird mit dem CVD-Verfahren eine dicke SiO₂-Schicht 23 abgelagert, die mit Hilfe des Masken- und Ätzverfahrens kammartig strukturiert wird, wodurch die Polysiliziumschicht freiliegt. Mit Hilfe der Plasmaätztechnik unter Berücksichtigung des Neigungswinkels wird die im kammartigen Fenster sich befindende Polysiliziumschicht 9 so weit geätzt, bis die SiN₄-Schicht 22 freigelegt wird. Dann wird die SiO₂-Schicht 23 naß weggeätzt, gleichzeitig bildet sich die trapezförmige Fläche aus Polysilizium 9 mit dem Neigungswinkel. Mit dem LOCOS-Verfahren wird auf dem Polysilizium 9 die trapezförmigen Wände 12 aus SiO₂ gebildet. Entsprechend Fig. 5B wird mit heißem H₃PO₄ die Si₃N₄-Schicht 22 und mit verdünnter BHF wird die SiO₂-Schicht 21 geätzt, wodurch die n-Epitaxieschicht 14 freigelegt wird. Auf die n-Epitaxieschicht 14 wird eine n⁻-Epitaxieschicht 4 aufgewachsen, wobei mit dem CMP-Verfahren die auf der trapezförmigen Fläche des Polysiliziums 9 befindende n⁻-Epitaxieschicht weggebracht wird. Auf diese Weise ist die gesamte Grundfläche geebnet und es entsteht der zueinander sich schräg erstreckende kammartige Isolationsgraben 5. Nachdem der Isolationsgraben gebildet ist, sind die weiteren Schritte des Herstellungsverfahrens des Bipolartransistors mit kammartigem Kollektor identisch mit denen, die in Fig. 4E bis 4G-B gezeigt sind.

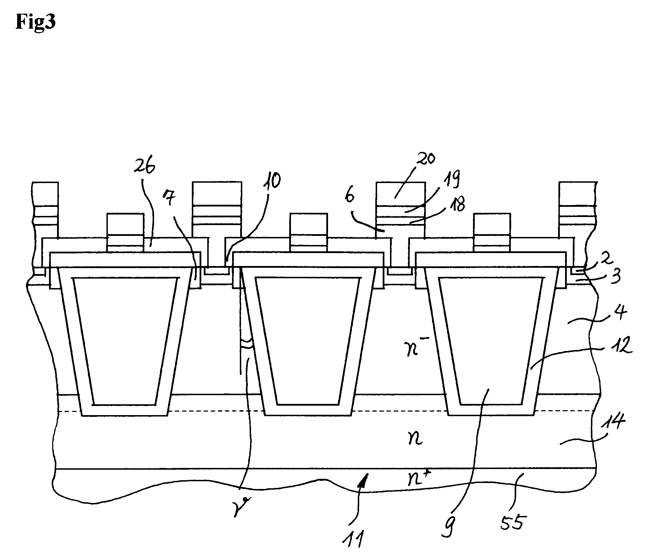

Fig. 3 zeigt eine weitere Ausführungsform des vertikalen Bipolartransistors. Bei diesem Transistor sind die Seitenwände 12 des Isolationsgrabens 5, die der Basis 2 und dem Kollektor 4 zugewandt sind, gegen die Vertikale unter einem bestimmten Winkel δ so geneigt, daß sie in die Richtung der Tiefe des Substrats 11 auseinanderlaufen. Durch diese Anordnung vergrößert sich der Querschnitt des Kollektors 4 in die Tiefe des Substrats 11 hin, wodurch ein verbesserter Wärmeabfluß aus dem Kollektorbereich 4 zum Substrat stattfinden kann.

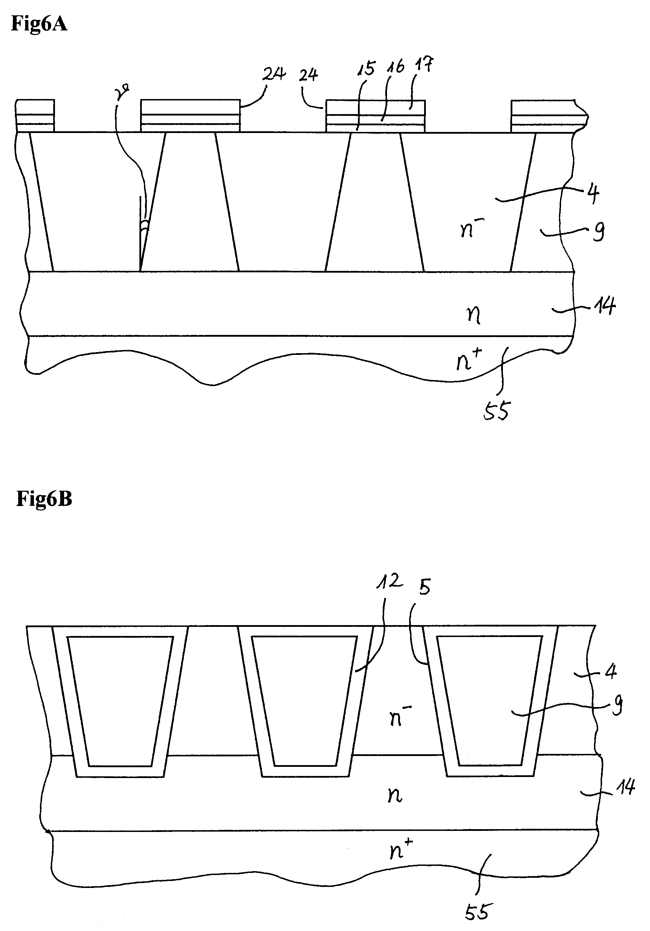

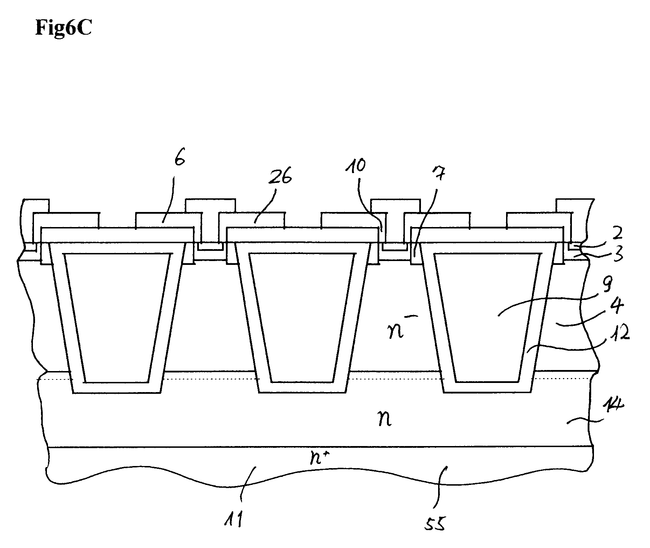

In den Fign. 6A bis 6C sind die Verfahrensschritte zur Herstellung des Transistors nach Fig. 4 dargestellt. Fig. 6A zeigt, daß zunächst ein Halbleitersubstrat vorgesehen ist, das aus einer n⁺-Siliziumschicht 55, einer n-Epitaxieschicht 14 und einer n⁻Epitaxieschicht 4 besteht. Auf der n⁻-Epitaxieschicht 4 wird mit dem CVD-Verfahren zunächst eine dreischichtige Isolationsstruktur aus dünnem SiO₂ 15, einer Si₃N₄-Schicht 16 und einer dicken SiO₂-Schicht 17 abgeschieden. Diese dreischichtige Isolationsstruktur wird mit Fenstern versehen, durch die hindurchgeätzt wird, und zwar bis zur n-Epitaxieschicht 14. Dadurch entsteht ein schräger kammartiger Grabenmit gewünschtem Neigungswinkel. Mittels der Si₃N₄-Schicht 16 als Abdeckung wird mit dem LOCOS-Verfahren eine SiO₂-Isolationsschicht auf der Innenwand des kammartigen schrägen Grabens gebildet und mit dem LPCVD-Verfahren wird undotiertes Polysilizium abgelagert, das den Graben füllt. Mit dem CMP-Verfahren wird die auf der Si₃N₄-Schicht 16 sich befindende undotierte Polysiliziumschicht weggebracht, damit die Oberfläche glatt wird. Anschließend wird das etwa 300 nm dicke undotierte Polysilizium auf der Oberfläche des kammartigen schrägen Grabens naß weggeätzt. Mit der Si₃N₄-Schicht 16 als Abdeckungsfolie bildet sich die SiO₂-Schicht auf der Oberfläche des kammartigen schrägen Grabens aus, worauf die Si₃N₄-Schicht 16 mittels H₃PO₄ und anschließend die Schicht 15 weggebracht wird. Entsprechend Fig. 6C sind die weiteren Schritte des Herstellungsverfahrens des Bipolartransistors mit kammartigem Kollektor identisch zu denen, die in Fig. 4 gezeigt sind.

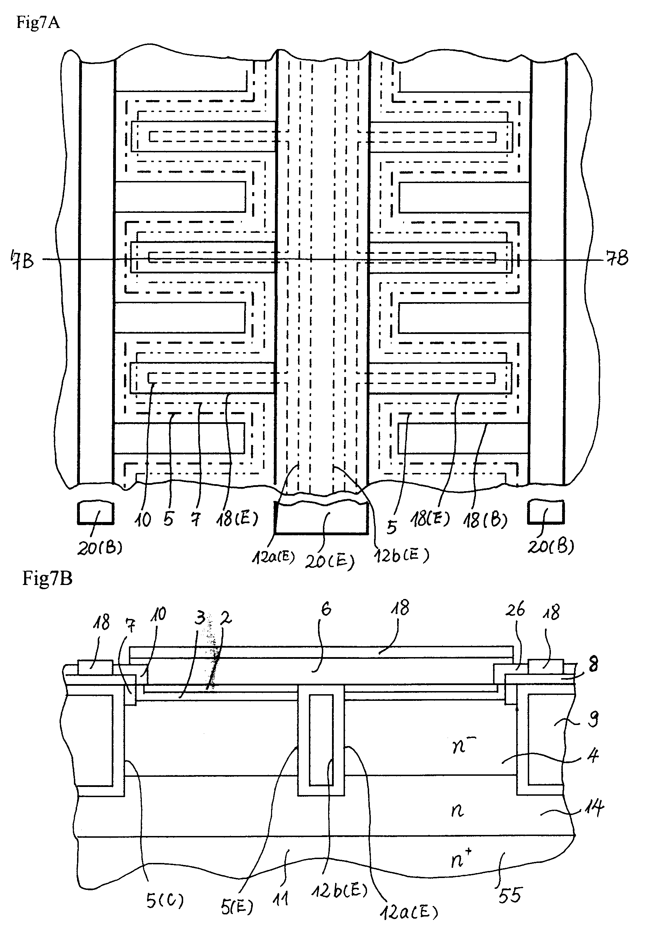

In den Fign. 7A bis 7C sind die Verfahrensschritte zur Herstellung des mit As dotierten Polysilizium/TiSi₂-Emitters, wobei die Fingerbreite des Emitters kleiner als 2 µm, die Länge größer als 10 µm ist. In Fig. 7A ist der Grundriß des vertikalen Transistors dargestellt, wobei 18(B) die TiSi₂-Schicht auf dem kammartigen Finger der Basiselektrode, 18(E) die TiSi₂-Schicht des Emitters, 20(B) die Al-Elektrode der Basiselektrode und 20(E) die Al-Elektrode der Emitterelektrode bedeuten. In gleicher Weise bezeichnen 5(C) den kammartigen Isolationsgrabend im wesentlichen im Kollektorbereich und 5(E) den Isolationsgraben der Emitterzone. Die Breite des Isolationsgrabens 5(E) liegt bei 0,5 bis 3 µm, die Tiefe bei 0,5 bis 15 µm. Der Isolationsgraben 5(E) hat die Funktion, daß C_{TE} von dem Übergang des Emitters vermindert wird.

Die gesamten Herstellungsschritte der Herstellung des mit As dotiertem n⁺-Siliziumsubstrats bis zur Entstehung des mit As dotiertem Polysiliziumemitters sind identisch zu denen, die in Zusammenhang mit Fig. 4 beschrieben wurden. Dies wird hier nicht wiederholt.

Entsprechend Fig. 7B sind Kontaktöffnungen der Basis auf dem p⁺-Polysilizium 8 und der SiO₂-Schicht 26 erzeugt. Auf der gesamten Oberfläche des Halbleitersubstrats wird dann eine Ti-Schicht mit etwa einer Dicke von 100 nm abgeschieden. Durch einen RTA-Prozeß bei Temperaturen von 500 bis 600° C wird die TI-Schicht behandelt, so daß auf der Polysiliziumoberfläche TiSi entsteht. Mit einer Lösung aus NH₄OH/H₂O₂/H₂O wird das unreagierte Ti oder das bei der RTA-Behandlung entstehende TiN weggeätzt und auf der mit p⁺-Polysilizium und Polysilizium dotierten Oberfläche gebildete TiSi wird bei hohen Temperaturen zum Beispiel 750° C unter N₂-Schutz mittels der RTA-Verfahrens in TiSi₂ gewandelt.

Die Schritte, mit denen der Polysilizium/TiSi₂-Emitter, dessen Breite kleiner als 2 µm ist, hergestellt wird, sind damit abgeschlossen. Er wurde mit Selbstjustierung und ohne Maske durchgeführt.

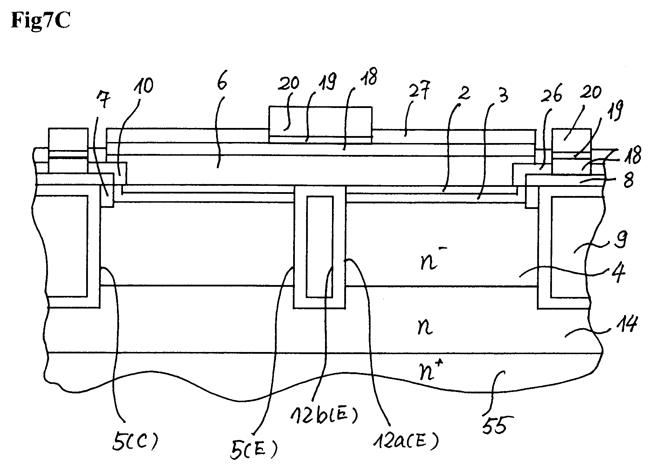

Entsprechend Fig. 7C wird zunächst eine SiO₂-Schicht 27 auf der gesamten Oberfläche abgelagert, dann wird diese mit einer Maske und dem RIE-Verfahren geätzt, so daß Kontaktfenster der Basis und des Emitters entstehen. Anschließend wird eine mehrschichtige metallisierte Struktur TiN/Ti/AlSiCu/ oder Au abgelagert. Durch weitere Maskierung und Abätzung wird ein mehrschichtiges metallisiertes System Polysilizium/TiSi/TiN/AlSiCu mit hoher Zuverlässigkeit hergestellt.

Die beigefügten Zeichnungen sollen in ihrer Darstellung und ihrem Offenbarungsgehalt ausdrücklich zur Erfindung gehören und alle Merkmale, die aus ihnen zu erkennen sind, betreffen den Offenbarungsgehalt der Erfindung.

## Patentansprüche

1. Vertikaler Bipoltransistor mit einer Emitterschicht (2), einer Basisschicht (3) und einer Kollektorschicht (4), die in vertikaler Richtung in unterschiedlichen Tiefen in einem Halbleitersubstrat (11) angeordnet ist und über ein Elektrodensystem metallisiert sind, wobei der von der Emitterschicht, der Basisschicht und der Kollektorschicht gebildete Bereich von einem Isolationsgraben umgeben ist,
**dadurch gekennzeichnet,**
daß die Kollektorschicht (4) und der Isolationsgraben (5) jeweils kammartig ausgebildet sind und jeweils ineinandergreifen, wobei die Querschnittsfläche des Bodens des kammartigen Isolationsgrabens (5) größer ist als die Übergangsfläche der Kollektorschicht (4) des Transistors zum Halbleitersubstrat (11) und der Isolationsgraben (5) vertikal über die Übergangsfläche bis in das Halbleitersubstrat (11) sich erstreckt und diese vollständig umgibt.

2. Bipoltransistor nach Anspruch 1, dadurch gekennzeichnet, daß der kammartige Isolationsgraben (5) eine Tiefe aufweist, die um etwa 2 µm größer als die Breite bzw. Tiefe der Raumladungszone bei Spannungen unterhalb der Durchbruchspannung ist, wobei er sich weiter über den Kollektorübergang des Transistors hinaus erstreckt.

3. Bipolartransistor nach Anspruch 2, dadurch gekennzeichnet, daß die Tiefe des Isolationsgrabens (5) zwischen 5 < T < 17 µm beträgt.

4. Bipolartransistor nach einem der Ansprüche 1 bis 3, dadurch gekennzeichnet, daß die Emitterschicht (2) aus einer Dreifachschicht mit einer n⁺-Emitterzone, einer dotierten n⁺-Polysiliziumschicht und einer Silizidschicht (TiSi₂) besteht, wobei die Silizidschicht selbstjustiert auf der dotierten n⁺-Polysiliziumschicht gebildet ist.

5. Bipolartransistor nach einem der Ansprüche 1 bis 4, dadurch gekennzeichnet, daß das Halbleitersubstrat (11) aus drei Schichten aus Silizium besteht, einer Grundschicht aus einem n⁺-Einkristallsilizium mit höherer Dotierung und niedrigerem Widerstand, einer ersten Epitaxieschicht, die sich auf der Oberfläche der Grundschicht bildet, und einer zweiten Epitaxieschicht, die sich auf der Oberfläche der ersten Epitaxieschicht bildet.

6. Bipolartransistor nach Anspruch 5, dadurch gekennzeichnet, daß die erste Epitaxieschicht vom mit As dotierten n-Typ ist, dessen Dotierungsdichte niedriger als die der Grundschicht ist und daß die zweite Epitaxieschicht vom mit As dotierten n⁻-Typ ist, dessen Dotierungsdichte niedriger als die der ersten Epitaxieschicht ist.

7. Bipolartransistor nach einem der Ansprüche 1 bis 6, dadurch gekennzeichnet, daß das metallisierte Elektrodensystem mehrschichtig ausgebildet ist und mindestens aus vier Schichten von leitenden Materialien besteht, einer ersten leitenden Schicht aus mit As dotiertem n⁺-Polysilizium, die mit der n⁺-Emitterzone verbunden ist,
einer zweiten leitenden Schicht aus TiSi₂, die sich selbstjustierend auf der Elektrodenschicht aus n⁺-Polysilizium in der Emitterzone des Transistors und auf der Elektrodenschicht aus p⁺-Polysilizium in der inaktiven Basiszone des Transistors bildet,
einer dritten leitenden Schicht aus TiN, die sich auf der Oberfläche der zweiten leitenden Elektrodenschicht bildet, und
einer vierten leitenden Schicht aus AlSiCu oder Au, die sich auf der Oberfläche der dritten leitenden Elektrodenschicht bildet.

8. Bipolartransistor nach einem der Ansprüche 1 bis 7, dadurch gekennzeichnet, daß der Isolationsgraben (5) als Füllungsmaterial (9) undotiertes Polysilizium aufweist, das von Seitenwänden und von einem Boden umgeben ist, die aus einer dünnen Schicht von thermischem Siliziumoxid bestehen.

9. Bipolartransistor nach einem der Ansprüche 1 bis 8, dadurch gekennzeichnet, daß die zu dem die Emitterschicht (2), Basisschicht (3) und Kollektorschicht (4) aufweisenden Bereich orientierten Wände des kammartigen Isolationsgrabens (5) rechtwinklig gegen den Kollektorübergang in die Tiefe des Substrats (11) erstrecken.

10. Bipolartransistor nach einem der Ansprüche 1 bis 8, dadurch gekennzeichnet, daß die zu dem die Emitterschicht, die Basisschicht und die Kollektorschicht aufweisenden Bereich orientierten Wände (12) des Isolationsgrabens (5) in Richtung des Substrats unter einem vorgegebenen Winkel gegen die Vertikale aufeinander zulaufen.

11. Bipolartransistor nach einem der Ansprüche 1 bis 8, dadurch gekennzeichnet, daß die zu dem die Emitterschicht, die Basisschicht und die Kollektorschicht enthaltenden Bereich orientierten Wände (12) des kammartigen Isolationsgrabens (5) in Richtung des Substrats unter einem vorgegebenen Winkel gegen die Vertikale auseinanderlaufen.

12. Bipolartransistor nach Anspruch 10 oder 11, dadurch gekennzeichnet, daß der Neigungswinkel zwischen 0 und 45° liegt.

13. Verfahren zur Herstellung eines vertikalen Bipolartransistors nach einem der vorhergehenden Ansprüche,
**gekennzeichnet durch** folgende Schritte:
a) ein einkristallines n⁺-Halbleitersubstrat (55) wird bereitgestellt,
b) auf dem einkristallinen Halbleitersubstrat wird nacheinander eine erste n-Epitaxieschicht und eine zweite n⁻-Epitaxieschicht gebildet, wodurch ein Halbleitersubstrat (11) entsteht,
c) auf diesem Halbleitersubstrat werden nacheinander drei Isolationsschichten (15,16,17) erzeugt, eine Siliziumoxidschicht, eine Siliziumnitridschicht und eine Siliziumoxidschicht,
d) ein Fenster eines kammartigen Isolationsgrabens wird in diesen Isolationsschichten (15,16,17) erzeugt und anschließend wird das Halbleitersubstrat (11) mit einem anisotropen Prozeß (RIE) bis auf die Oberfläche der ersten n-Epitaxieschicht geätzt, um im Halbleitersubstrat (11) den kammartigen Graben zu bilden,
e) an den Innenwänden des kammartigen Grabens wird eine SiO₂-Isolationsschicht erzeugt und anschließend der Graben mit Polysilizium aufgefüllt, wodurch der kammartige Isolationsgraben (5) entsteht,
f) auf dem Halbleitersubstrat (11) wird eine p⁺-Polysiliziumschicht abgeschieden und so strukturiert, daß auf der Oberfläche des kammartigen Grabens (5) eine p⁺-Polysiliziumstruktur als Anschluß der inaktiven Basiszone des Transistors entsteht, die der Struktur des kammartigen Isolationsgrabens (5) entspricht und deren kammartige Streifen breiter als die Streifen des kammartigen Isolationsgrabens (5) sind,
g) durch die Ausdiffusion von im p⁺-Polysilizium enthaltenen Bor-Atomen in die n⁻-Epitaxieschicht und durch die Bor-Ionen-Implantation wird selbstjustiert ein kammartiger Kollektor gebildet, wobei die Übergangsfläche des kammartigen Kollektors zum Isolationsgraben (5) rechtwinklig gegen die Seitenwände des kammartigen Grabens angeordnet ist,
h) eine Bor enthaltende Glasschicht als Isolationsschicht der Seitenwände des Emitters wird abgelagert,
i) und ein mit As dotierter Polysiliziumemitter wird gebildet,
j) durch die Abscheidung einer Ti-Schicht und durch einen anschließenden RTA-Prozeß wird auf der p⁺-Polysiliziumschicht in der Basisanschlußöffnung und auf der mit As dotierten Polysiliziumschicht des Emitters selbstjustiert eine TiSi₂-Schicht erzeugt, wodurch ein Polysilizium/TiSi₂-Emitter gebildet wird,
k) durch die Abscheidung einer TiN-Schicht und einer AlSiCu-Schicht oder Au-Schicht wird ein mehrschichtig metallisiertes Elektrodensystem gebildet,
l) es wird eine Passivierungsschicht gebildet,
m) Kontaktzonen für den Emitter und die Basis für Außenanschlüsse werden gebildet.

14. Verfahren zur Herstellung des Transistors mit geneigtem kammartigen Isolationsgraben nach Anspruch 10, gekennzeichnet durch folgende Schritte:
a) Bildung einer n-Epitaxieschicht auf dem n⁺-Einkristallsiliziumsubstrat (55) und anschließend Erzeugung einer Zweifachisolationsschicht durch die Bildung einer dünnen Siliziumoxidschicht und die anschließende Abscheidung einer Siliziumnitridschicht,
b) Aufwachsen einer epitaktischen Polysiliziumschicht (9) von 5 bis 17 µm auf der obengenannten Zweifachisolationsschicht,
c) Abscheidung einer SiO₂-Schicht auf der obengenannten Polysiliziumschicht,
d) Strukturierung der obengenannten SiO₂-Schicht in Form vom Fenster eines kammartigen Kollektors und anschließend Ätzung der Polysiliziumschicht (9) im Fenster des kammartigen Kollektors, so daß die Zweifachisolationsschicht auf der n-Epitaxieschicht (14) freigelegt wird und gleichzeitig eine kammartige Mesa-Struktur von Polysilizium (9) entsteht,
e) Bildung einer SiO₂-Schicht an den seitlichen Wänden der Mesa-Struktur der kammartigen Polysiliziumschicht,
f) Entfernung der freigelegten Zweifachisolationsschicht auf dem n⁺-Einkristallsiliziumsubstrat durch Ätzung, so daß diese n-Epitaxieschicht (14) freigelegt wird,
g) Aufwachsen einer n⁻-Epitaxieschicht (4) auf der freigelegten n-Epitaxieschicht (14),
h) Entfernung der n⁻-Epitaxieschicht (4) und der n-Epitaxieschicht auf der Oberfläche der obengenannten kammartigen Polysilizium-Mesa-Struktur, so daß die gesamte Oberfläche des Substrats geebnet wird und der kammartige Graben mit aufeinanderzulaufend geneigten Wänden gebildet wird.

15. Verfahren zur Herstellung des Transistors mit geneigtem kammartigen Isolationsgraben nach Anspruch 11, gekennzeichnet durch folgende Schritte:
a) Erzeugung einer Dreifachisolationsschicht durch die nacheinander erfolgte Bildung einer Siliziumoxidschicht, einer Siliziumnitridschicht und einer Siliziumoxidschicht auf der Oberfläche des Halbleitersubstrats (11).
b) Strukturierung der obengenannten Dreifachisolationsschicht in Form vom Fenster eines kammartigen Isolationsgrabens, so daß das Halbleitersubstrat (11) freigelegt wird,
c) Ätzung des Halbleitersubstrats innerhalb des Fensters der obengenannten Dreifachisolationsschicht bis auf die Oberfläche der n-Epitaxieschicht, so daß der kammartige Graben entsteht,
d) Bildung einer SiO₂-Isolationsschicht an den inneren Wänden des geneigten kammartigen Grabens und anschließend Füllung des Grabens mit Polysilizium,
e) Entfernung aller Polysiliziumschicht auf dem Halbleitersubstrat außer der Zone des geneigten kammartigen Grabens und anschließend Bildung einer SiO₂-Schicht auf der Oberfläche des geneigten kammartigen Grabens, so daß der kammartige Graben mit auseinanderlaufend geneigten Wänden gebildet wird.

16. Verfahren zur Herstellung eines Polysilizium/Silizid-Emitters des vertikalen Transistors nach Anspruch 4, gekennzeichnet durch folgende Schritte:
a) Bildung eines mit As dotierten Polysiliziumemitters und anschließend Erzeugung der Kontaktöffnung der Basisanschlüsse,
b) Abscheidung einer Ti-Schicht auf der gesamten Oberfläche des Halbleitersubstrats,
c) Bildung einer TiSi-Schicht auf der Oberfläche des Polysiliziums durch einen RTA-Prozeß mit niedrigerer Temperatur,
d) Entfernung von nicht reagiertem Ti (bzw. im RTA-Prozeß entstandenem TiN) auf der SiO₂-Oberfläche durch eine selektive Ätzung mit einer gemischten Lösung von NH₄OH/H₂O₂/H₂O,
e) Bildung einer TiSi₂-Schicht durch einen RTA-Prozeß mit höherer Temperatur.
